# EUROPÄISCHE PATENTANMELDUNG

(11) **EP 2 933 850 A1**
(43) Veröffentlichungstag der Anmeldung: **21.10.2015**
(21) Anmeldenummer: 14183851.6
(22) Anmeldetag: 05.09.2014
(51) Int. Cl.: H01L 51/00, C07F 1/08, C09K 11/06

(54) **Metallkomplexe als Emittermaterialien**

(30) Priorität: 15.04.2014 EP 14164815
(71) Anmelder: cynora GmbH, 76646 Bruchsal (DE)
(72) Erfinder: Volz, Daniel, 76137 Karlsruhe (DE); Friedrichs, Jana, 76137 Karlsruhe (DE); Zink, Daniel, 76646 Bruchsal (DE)
(74) Vertreter: Hoppe, Georg Johannes

(57) **Zusammenfassung**

Die Erfindung betrifft ein Molekül aufweisend eine Struktur der Formel A sowie dessen Verwendung in optoelektronischen Bauelementen, insbesondere OLEDs. 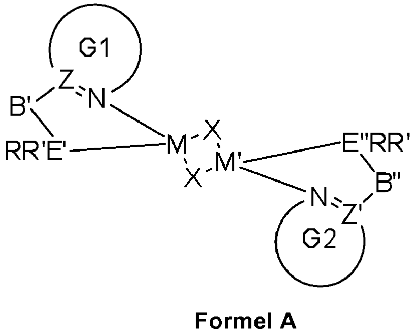 wobei
M/M' = unabhängig ausgewählt aus der Gruppe bestehend aus Cu, Ag, Au;
X = unabhängig ausgewählt aus der Gruppe bestehend aus Cl, Br, I, Pseudohalogenide;
E'/E" = unabhängig ausgewählt aus der Gruppe bestehend aus P, As;
Z/Z' = unabhängig ausgewählt aus der Gruppe bestehend aus N oder C; wobei zwischen
Z/Z' und N entweder eine Einfachbindung oder eine Doppelbindung vorhanden ist;
B'/B" = Brücke mit mindestens 2 bis zu 17 Gliedern.

## Beschreibung

Die Erfindung betrifft Metallkomplexe (Emittermaterialien) und deren Verwendung als Emitter in optoelektronischen Bauelementen, insbesondere OLEDs (organic light emitting diodes), sowie als Sensoren.

### Einleitung

Die auf OLED (Organic Light Emitting Diodes) basierende Technologie hat sich in den letzten Jahren im Bereich von Beleuchtungs- und Displayapplikationen als kostengünstige und energieeffiziente Technik durchgesetzt. Entsprechende Produkte sind bereits heute kommerziell erhältlich und werden in verschiedensten Arten von opto-elektronischen Bauelementen eingesetzt.

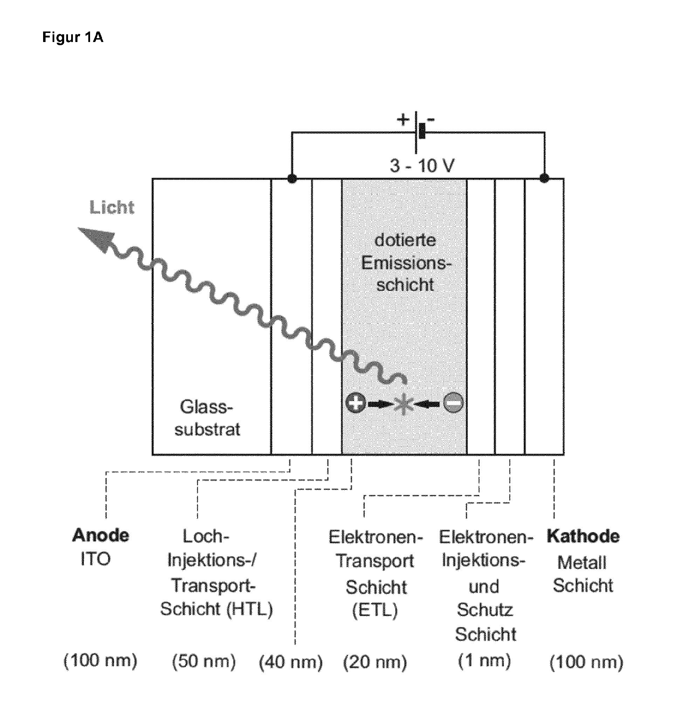

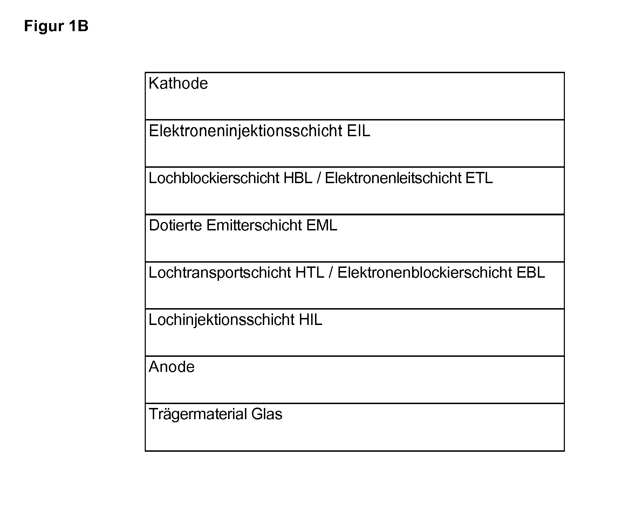

In der Regel sind derartige Bauteile in Schichtstrukturen realisiert, welche überwiegend aus organischen Materialien bestehen. Zum besseren Verständnis ist in Figur 1A/B ein vereinfachter Aufbau exemplarisch dargestellt. Herzstück solcher Bauteile ist die Emitterschicht, welche typischerweise zwischen einer Anode und einer Kathode angeordnet ist und die in der Regel aus einem Hostmaterial besteht, in welches die emittierenden Moleküle eingebettet sind. Weitere Schichten, wie die Lochinjektionsschicht, die Lochtransportschicht, die Elektronenleitschicht und die Zwischenschicht bewirken im Allgemeinen eine dramatisch verbesserte Effizienz der Bauteile. Bei Anlegen eines Stroms/einer Spannung treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Die der Erfindung zu Grunde liegende Aufgabe besteht in der Bereitstellung neuer Emittermaterialien mit verbesserten Eigenschaften.

### Beschreibung

Es wurden überraschend neue Emittermaterialien gefunden.

Die erfindungsgemäßen Moleküle umfassen zweikernige Metallkomplexe, aufweisend eine Struktur gemäß Formel A oder bestehend aus einer Struktur gemäß Formel A 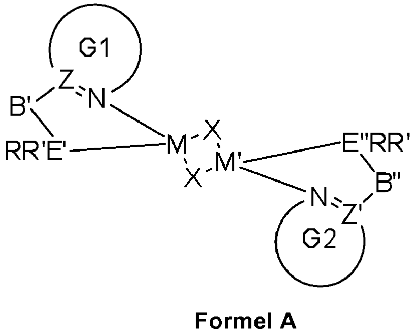 wobei
M/M' = unabhängig ausgewählt aus der Gruppe bestehend aus Cu, Ag, Au;
X = unabhängig ausgewählt aus der Gruppe bestehend aus Cl, Br, I, Pseudohalogenide;
E'/E" = unabhängig ausgewählt aus der Gruppe bestehend aus P, As;
Z/Z' = unabhängig ausgewählt aus der Gruppe bestehend aus N oder C; wobei zwischen
Z/Z' und N entweder eine Einfachbindung oder eine Doppelbindung vorhanden ist;
B'/B" = Brücke mit mindestens 2 bis zu 17 Gliedern; die Glieder können bestehen aus CH₂, CHR'", CR'"R"", O, S, Se, NR"', PR"', AsR"', wobei R'" ein Rest ausgewählt aus der Gruppe bestehend aus Alkyl, Aryl, Hereroaryl, OR, SR, SeR, H, D ist;

G1/G2 = fünf oder sechsgliedriges, heteroaromatisches Ringsystem, welches optional mit weiteren Resten wie R/R' substituiert oder mit weiteren aromatischen Ringen anneliert ist; einer der Reste an G1/G2 kann auch eine weitere Brücke sein, die eine Brücke wie B'/B" aufspannt; durch diese Brücke wird das Ringsystem G1 mit dem Donoratom E" und das Ringsystem G2 mit dem Donoratom E' verbunden;
jedes R und R' ist bei jedem Auftreten gleich oder verschieden H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R und R' auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

In einer Ausführungsform ist B'/B" eine organische Brücke mit mindestens 2 bis zu 17 Gliedern, die eine substituierte oder unsubstituierte Alkylen-, Alkenylen-, Alkinylen- oder Arylen-Gruppe oder eine Kombination dieser, oder -O-, -NR-, -C=CR₂, -C=NR, -SiR₂- -S-,-S(O)-, -S(O)₂-, durch O unterbrochene Alkyl- (auch verzweigt oder zyklisch), Heteroalkyl-, Aryl-, Heteroaryl-, Alkenyl-Gruppen, Phenyl- und substituierte Phenyleinheiten ist.

In einer weiteren Ausführungsform ist B'/B" eine bivalente organische Brücke, die eine substituierte oder unsubstituierte Alkylen- (auch verzweigt oder zyklisch), Alkenylen-, Alkinylen-, Arylen-, Heteroarylen-Gruppe, O, NR, C=CR₂, C=NR, SiR₂ S, S(O), S(O)₂, BR, PR, P(O)R, oder eine Kombination dieser Einheiten ist (z.B. durch O unterbrochene Alkylen-(auch verzweigt oder zyklisch), Alkenylen-, Alkinylen-, Arylen- und Heteroarylen-Gruppen).

In einer Ausführungsform weisen die zweikernigen Metallkomplexe der Formel A eine Struktur gemäß Formel A' auf: 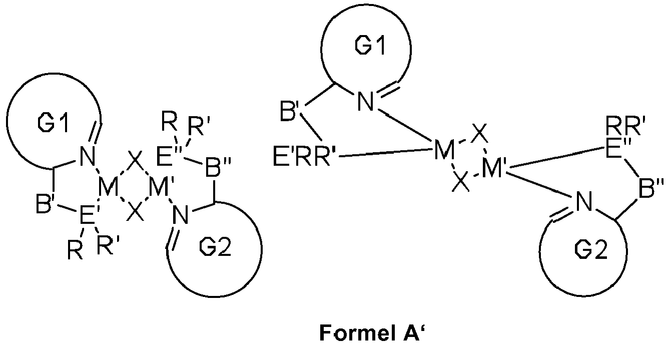 wobei die gleichen Definitionen wie für Formel A gelten.

In einer weiteren Ausführungsform ist das Ringsystem G1/G2 ausgewählt aus der Gruppe bestehend aus einer ungesättigten oder aromatischen N-heterozyklischen Einheit mit 5 bis 6 Ring-Atomen, die ausgewählt ist aus der Gruppe bestehend aus Pyridin, Pyridazin, Pyrimidin, Pyrazin, Triazin, Oxazol, Thiazol, Imidazol, Pyrazol, Isoxazol, Isothiazol, 1,2,3-Triazol, 1,2,4-Triazol, 1,2,4-Oxadiazol, 1,2,4-Thiadiazol, Tetrazol, 1,2,3,4-Oxatriazol, 1,2,3,4-Thiatriazol, die mit einem oder mehreren Resten R substituiert sein können, wobei zwei oder mehr Reste R miteinander verknüpft sein können und einen Ring bilden können, wobei die Reste R zusammen mit dem zentralen 5- bis 6-Ring auch anellierte Ringsysteme ausbilden können,
wobei die Koordination an das M/M'-Atom über ein Stickstoffatom der N-heterozyklischen Einheit stattfindet: 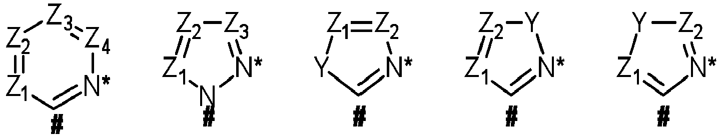 mit
(Verknüpfung zu B und zu B' findet an der mit # gekennzeichneten Stelle statt, * kennzeichnet das Atom, das die Komplexbindung eingeht)
Z¹-Z⁴ = jeweils unabhängig voneinander ausgewählt aus der Gruppe bestehend aus dem Fragment CR und N, mit R ist bei jedem Auftreten gleich oder verschieden H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R², S(=O)₂R³, OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

In einer Ausführungsform ist R³ ein organischer Rest, der unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen bzw. substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind. Die Reste R³ führen optional auch zu annelierten Ringsystemen.

Die Komplexstrukturen können, zwei, drei oder vier Brücken aufweisen. In einer Ausführungsform weisen die zweikernigen Metallkomplexe der Formel A zwei Brücken auf: 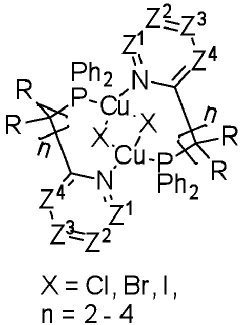 wobei die gleichen Definitionen wie für Formel A gelten, und wobei in einer bevorzugten Ausführungsform Z¹ bis Z⁴ gleich CR sind.

In einer weiteren Ausführungsform weisen die zweikernigen Metallkomplexe der Formel A drei Brücken auf: 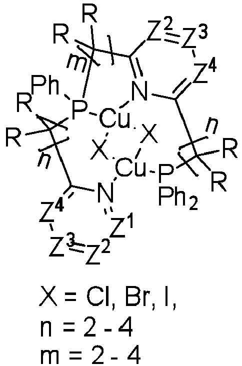 wobei die gleichen Definitionen wie für Formel A gelten, und wobei in einer bevorzugten Ausführungsform Z¹ bis Z⁴ gleich CR sind.

In einer weiteren Ausführungsform weisen die zweikernigen Metallkomplexe der Formel A vier Brücken auf: 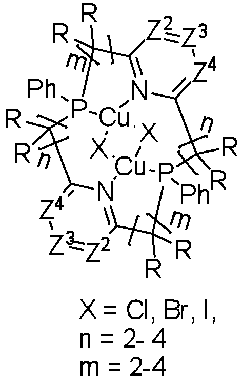 wobei die gleichen Definitionen wie für Formel A gelten, und wobei in einer bevorzugten Ausführungsform Z² bis Z⁴ gleich CR sind.

In einer weiteren Ausführungsform weisen die zweikernigen Metallkomplexe der Formel A eine Struktur gemäß Formel B auf: 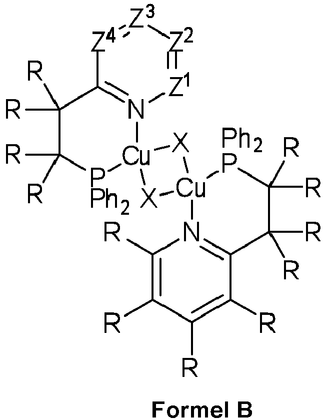 wobei die gleichen Definitionen wie für Formel A gelten, und wobei in einer bevorzugten Ausführungsform Z¹ bis Z⁴ gleich CR sind.

In einer weiteren bevorzugten Ausführungsform weisen die zweikernigen Metallkomplexe der Formel A folgende Strukturen auf:

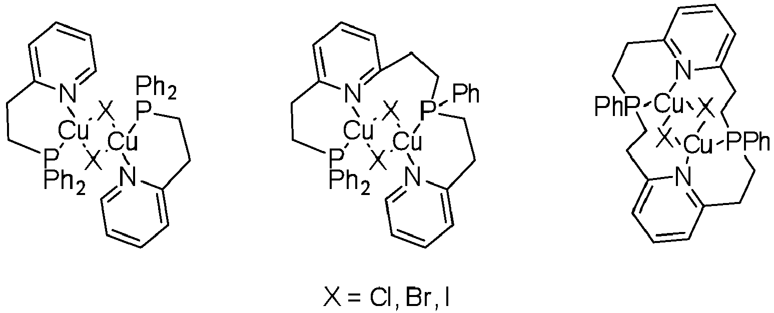

In einer weiteren Ausführungsform weisen die Liganden für Komplexe mit 2 Brücken folgende Strukturen auf:

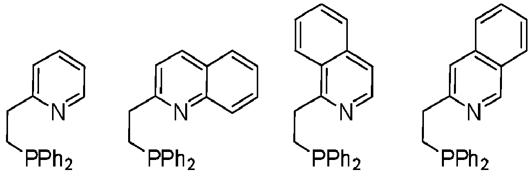

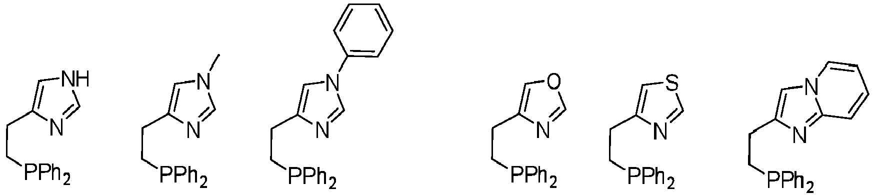

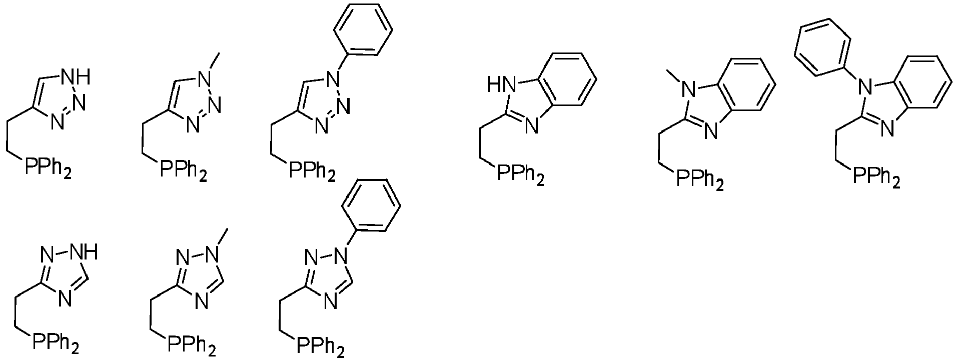

In einer weiteren Ausführungsform können die Liganden für Komplexe mit 2 Brücken an folgenden Positionen der Brücke variiert werden:

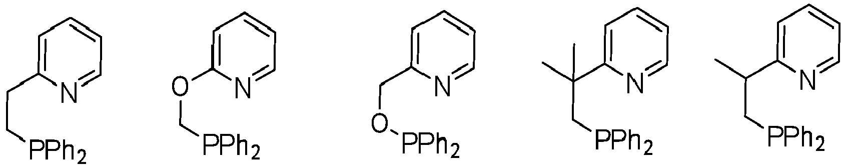

Die Erfindung erlaubt die Verwendung der Basis-artigen Komplexe in OLEDs, insbesondere als blaue Emitter.
In einer Ausführungsform der Erfindung weisen die Komplexe die nachfolgenden Strukturen auf:

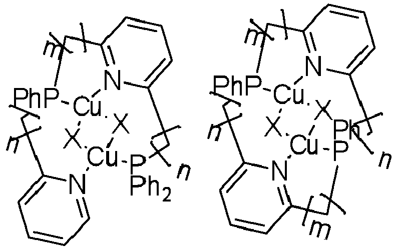

Für die beiden obigen Strukturen wurden Dichtefunktionaltheorie basierte Rechnungen (DFT-Rechnungen) durchgeführt. Der Komplex mit m=2, n=2 und X=Br, sowie der Komplex mit m = 3, n=3 und X=Br ist laut DFT-Rechnungen intrinsisch stabil und zeigt einen dem Basis-System ähnlichen MXLCT-Übergang.

In einem weiteren Aspekt betrifft die Erfindung ein Verfahren zur Herstellung eines zweikernigen Metallkomplexes der hier beschriebenen Art, aufweisend den Schritt der Substitution mindestens eines Liganden E∩D mit mindestens einer funktionellen Gruppe zur Verbesserung des Ladungsträgertransports, die ausgewählt ist aus Elektronenleiter und Lochleiter.

In einem weiteren Aspekt betrifft die Erfindung die Verwendung des erfindungsgemäßen Metallkomplexes 6 als Emitter oder Absorber in einem optoelektronischen Bauelement, das durch ein Vakuumverdampfungsverfahren oder aus Lösung hergestellt wird. Das optoelektronische Bauelement kann ausgewählt sein aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- Organischen Solarzellen,
- Organischen Feldeffekttransistoren,
- Organischen Lasern und
- Down-Konversions-Elementen.

Der Anteil des Metallkomplexes am Emitter oder Absorber beträgt in einer Ausführungsform der Anwendung 100 %. In einer alternativen Ausführungsform beträgt der Anteil des Metallkomplexes am Emitter oder Absorber 1 % bis 99 %. In einer Ausführungsform der Erfindung beträgt der Anteil des Metall(I)komplexes als Emitter in optischen Licht emittierenden Bauelementen, insbesondere in OLEDs, zwischen 5 % und 80 %.

In einem weiteren Aspekt betrifft die Erfindung ein optoelektronisches Bauelement, aufweisend einen erfindungsgemäßen Metallkomplex der hier beschriebenen Art. Das optoelektronisches Bauelement kann ausgeformt sein als ein Bauelement ausgewählt aus der Gruppe bestehend aus organischem lichtemittierendem Bauelement, organischer Diode, organischer Solarzelle, organischem Transistor, organischer lichtemittierender Diode, Lichtemittierender elektrochemischer Zelle, organischem Feldeffekttransistor und organischem Laser.

In einer Ausführungsform des optoelektronischen Bauelements wird der erfindungsgemäße Metallkomplex als Emissionsmaterial in einer Emissionsschicht des Bauelements eingesetzt, wobei er entweder als Reinschicht oder in Kombination mit einem Matrixmaterial eingesetzt ist.

Der Anteil des Metallkomplexes als Emissionsmaterial in einer Emissionsschicht in optischen Licht emittierenden Bauelementen, insbesondere in OLEDs, beträgt in einer Ausführungsform zwischen 5 % und 80 %.

Das Matrixmaterial für den erfindungsgemäßen Metallkomplex ist ausgewählt ist aus der Gruppe bestehend aus Ketonen, Phosphinoxiden, Sulfoxiden, Sulfonen, Triarylaminen, Carbazolderivaten, Phenoxazinderivaten, Phenothiazinderivaten, Indolocarbazolderivaten, Azacarbazolen, bipolaren Matrixmaterialien, Silanen, Azaborolen, Boronestern, Triazinderivaten, Zinkkomplexen, Diazasilol- bzw. Tetraazasilol-Derivaten, Benzophenonderivaten, Diphenylmethanderivate, Ultra-High-Energy-Gap-Matrixmatrialien (UHG-Matrixmaterialien oder Wide-Gap-Matrixmaterialien genannt, wobei der Energieabstand S0-T1 des Matrixmaterials mindesten 10 meV, bevorzugt 50 meV und besonders bevorzugt mindestens 100 meV größer ist als der Energieabstand S0-T1 eines eindotierten Metallkomplexes.) oder Mischungen aus zwei oder mehr dieser Matrixmaterialien.

In einer Ausführungsform weist das optoelektronische Bauelement ein Substrat und mindestens eine lichtemittierende Schicht auf, die einen hier beschriebenen Metallkomplex aufweist, wobei die lichtemittierende Schicht auf das Substrat aufgebracht ist.

In einer weiteren Ausführungsform weist das optoelektronische Bauelement ein Substrat, eine Anode, eine Kathode und mindestens eine lichtemittierende Schicht auf, die einen hier beschriebenen Metallkomplex aufweist, wobei die Anode und die Kathode auf das Substrat aufgebracht ist und die lichtemittierende Schicht zwischen Anode und Kathode aufgebracht ist.

Gemäß einer weiteren Ausführungsform weist das optoelektronische Bauelement ein Substrat, eine Anode, eine Kathode und mindestens eine lichtemittierende Schicht auf, die ausschließlich einen Metallkomplex in 100 % Konzentration aufweist, wobei die Anode und die Kathode auf das Substrat aufgebracht ist, und die lichtemittierende Schicht zwischen Anode und Kathode aufgebracht ist.

Das optoelektronische Bauelement weist in einer Ausführungsform ein Substrat, eine Anode, eine Kathode und mindestens eine lichtemittierende Schicht auf, die einen Metallkomplex der hierin beschriebenen Art und ein Hostmaterial aufweist, dessen Triplett (T1)- und Singulett (S1)-Energieniveaus energetisch höher liegen als die Triplett (T1)- und Singulett (S1)-Energieniveaus des Metallkomplexes, wobei die Anode und die Kathode auf das Substrat aufgebracht sind und die lichtemittierende Schicht zwischen Anode und Kathode aufgebracht ist.

In einer weiteren Ausführungsform weist das optoelektronische Bauelement mindestens je eine löcher- und elektroneninjizierende Schicht, und mindestens je eine löcher- und elektronentransportierende Schicht auf, wobei die löcher- und elektroneninjizierende Schicht zwischen Anode und Kathode aufgebracht ist, und die löcher- und elektronentransportierende Schicht zwischen der löcher- und der elektroneninjizierenden Schicht aufgebracht ist, und die lichtemittierende Schicht zwischen löcher- und elektronentransportierende Schicht aufgebracht ist.

In einem weiteren Aspekt betrifft die Erfindung ein Verfahren zur Herstellung eines optoelektronischen Bauelements, wobei ein Metallkomplex der hierin beschriebenen Art verwendet wird.

In einer Ausführungsform des Verfahrens wird der Metallkomplex auf einen Träger aufgebracht. Das Aufbringen kann nass-chemisch, mittels kolloidaler Suspension oder mittels Sublimation erfolgen.

In einem weiteren Aspekt betrifft die Erfindung ein Verfahren zur Veränderung der Emissions- und/oder Absorptionseigenschaften eines elektronischen Bauelements, wobei ein Metall(I)komplex der hier beschriebenen Art in ein Matrixmaterial zur Leitung von Elektronen oder Löchern eines optoelektronischen Bauelements eingebracht wird.

In einem weiteren Aspekt betrifft die Erfindung ein Verfahren zur Herstellung eines optoelektronischen Bauelements der beschriebenen Art in Form einer organischen Elektrolumineszenzvorrichtung. Dabei werden eine oder mehrere Schichten mit einem Sublimationsverfahren, oder mit einem OVPD (Organic Vapour Phase Deposition) Verfahren, oder mit Hilfe einer Trägergassublimation oder mit einem beliebigen Druckverfahren beschichtet.

In einem weiteren Aspekt betrifft die Erfindung die Verwendung eines erfindungsgemäßen Metallkomplexes, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

In einem weiteren Aspekt betrifft die Erfindung eine Zusammensetzung, aufweisend einen erfindungsgemäßen Metallkomplex und ein Hostmaterial, wobei die Triplett (T1)- und Singulett (S1)-Energieniveaus des Hostmaterials energetisch höher liegen als die Triplett (T1)- und Singulett (S1)-Energieniveaus Metallkomplexes, und wobei der Metallkomplex Fluoreszenz oder thermisch aktivierte verzögerte Fluoreszenz zeigt, und einen deltaE(S1-T1)-Wert zwischen dem untersten angeregten Singulett (S1)- und dem darunter liegenden Triplett (T1)-Zustand von kleiner als 2000 cm⁻¹ aufweist.

In einem weiteren Aspekt betrifft die Erfindung ein Verfahren zur Veränderung der Emissions- und/oder Absorptionseigenschaften eines elektronischen Bauelements, gekennzeichnet durch Einbringen eines erfindungsgemäßen Metallkomplexes mittels Vakuumverdampfung.

### Beispiele

### Allgemeine Synthesevorschrift:

**AAV 2: Herstellung von Komplexen ohne Ultraschallbehandlung (Cu₂X₂(N**,P**)₂** Das entsprechende Kupfersalz (1.00 Äquiv., 1.00 mmol), die Liganden (1.50 Äquiv., 1.50 mmol;) werden unter Stickstoff in einem 20 mL Crimp-Vial mit Rührfisch vorgelegt. Die Mischung wird mit 10 mL trockenem Dichlormethan versetzt. Die Reaktion wird gerührt bis eine klare, zumeist gelbe Lösung vorlag. Die Reaktionsmischung wurde über einen Spritzenfilter (0.45 µm) filtriert und in mind. 50-fachem Volumenüberschuss Methanol, Diethylether oder n-Hexan ausgefällt. Die Produkte wurden abfiltriert und unter vermindertem Druck getrocknet.

### Beispiel 1 Synthese von (2-(2-Diphenylphosphino)-ethyl-pyridin)₂Cu₂Cl₂ (10-Cl)

Der Komplex wurde nach der allgemeinen Synthesevorschrift in MeCN hergestellt und aus heißem MeCN kristallisiert. Der Komplex wurde filtriert und am Vakuum getrocknet. Gelbe Kristalle (70% Ausbeute). FAB-MS *m*/*z* (%): 778 [M⁺], 745 [M-Cl⁺], 645 [M-Cl-L⁺], 454 [M-L-Cl⁺], 389 [M-CuLCl⁺], 354 [M-CuCl₂L⁺]. - IR (ATR) 3044 (vw), 1593 (w), 1562 (vw), 1475 (m), 1448 (w), 1432 (s), 1310 (vw), 1262 (vw), 1184 (vw), 1096 (m), 1069 (w), 1025 (vw), 1009 (w), 898 (vw), 871 (m), 771 (s), 743 (vs), 694 (vs), 694 (vs), 675 (s), 636 (w), 522 (s), 503 (s), 478 (s), 414 (m) cm⁻¹. - C₃₈H₃₆N₂P₂Cu₂Cl₂: ber. C 58.47; H 4.65; N 3.59; gef. C 58.43, H 4.64, N 3.20.

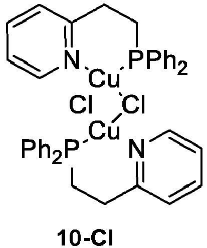

### Beispiel 2 Synthese von (2-(2-Diphenylphosphino)-ethyl-pyridin)₂Cu₂Br₂ (10-Br)

Der Komplex wurde nach der allgemeinen Synthesevorschrift in MeCN hergestellt und aus heißem MeCN kristallisiert. Der Komplex wurde filtriert und am Vakuum getrocknet. Gelbe Kristalle (90% Ausbeute). - ¹H NMR (500 MHz, Chloroform-d) 5 = 9.05 (d, *J* = 5.6 Hz, 2H), 7.67 (ddd, *J* = 9.9, 6.2, 4.2 Hz, 10H), 7.34 (dt, *J* = 29.8, 7.5 Hz, 13H), 7.22 (dd, *J* = 7.6, 5.2 Hz, 4H), 3.12 (dt, *J* = 21.4, 6.6 Hz, 4H), 2.57 (q, *J* = 5.9 Hz, 4H) ppm. - ¹³C NMR (126 MHz, Chloroform-*d*) 5 = 160.7, 138.0, 133.2, 132.9, 130.0, 128.7, 124.4, 122.6, 32.4, 26.5 ppm.-³¹P NMR (202 MHz, Chloroform-d) 5 = -12.2 ppm. - FAB-MS *m*/*z* (%): 870 [M⁺], 789 [M-Br⁺], 645 [M-Br-L⁺], 435 [M-CuLBr⁺], 354 [M-CuBr₂L⁺]. - IR (ATR) 3049 (vw), 1593 (w), 1562 (vw), 1476 (m), 1430 (m), 1308 (w), 1263 (vw), 1182 (vw), 1095 (m), 1068 (w), 1024 (w), 1010 (w), 870 (m), 768 (s), 740 (vs), 692 (vs), 673 (s), 636 (m), 522 (s), 499 (s), 476 (s), 456 (m), 412 (m) cm⁻¹. - C₃₈H₃₆N₂P₂Cu₂Br₂: ber. C 52.49; H 4.17; N 3.22; gef. C 52.40, H 4.17, N 3.01.

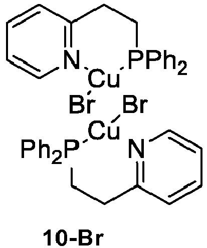

### Beispiel 3 Synthese von (2-(2-Diphenylphosphino)-ethyl-pyridin)₂Cu₂I₂ (10-I)

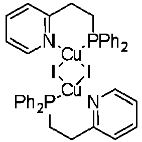

Der Komplex wurde nach der allgemeinen Synthesevorschrift in MeCN hergestellt und aus heißem MeCN kristallisiert. Der Komplex wurde filtriert und am Vakuum getrocknet. Farblose Kristalle (92% Ausbeute). - FAB-MS *m*/*z* (%): 836 [M-I⁺], 645 [M-I-L⁺], 4354 [M-CuI₂L⁺]. - IR (ATR) 3045 (vw), 1598 (w), 1565 (w), 1478 (m), 1431 (s), 1406 (w), 1322 (w), 1157 (w), 1099 (w), 1017 (w), 993 (w), 932 (w), 847 (w), 778 (w), 743 (vs), 718 (s), 693 (vs), 588 (w), 520 (vw), 499 (s), 475 (m), 443 (m), 413 (m) cm⁻¹. - C₃₈H₃₆N₂P₂Cu₂I₂: ber. C 47.37; H 3.77; N 2.91; gef. C 47.40, H 3.74, N 2.78.

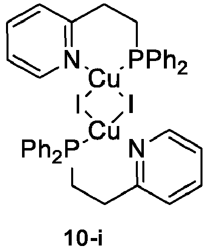

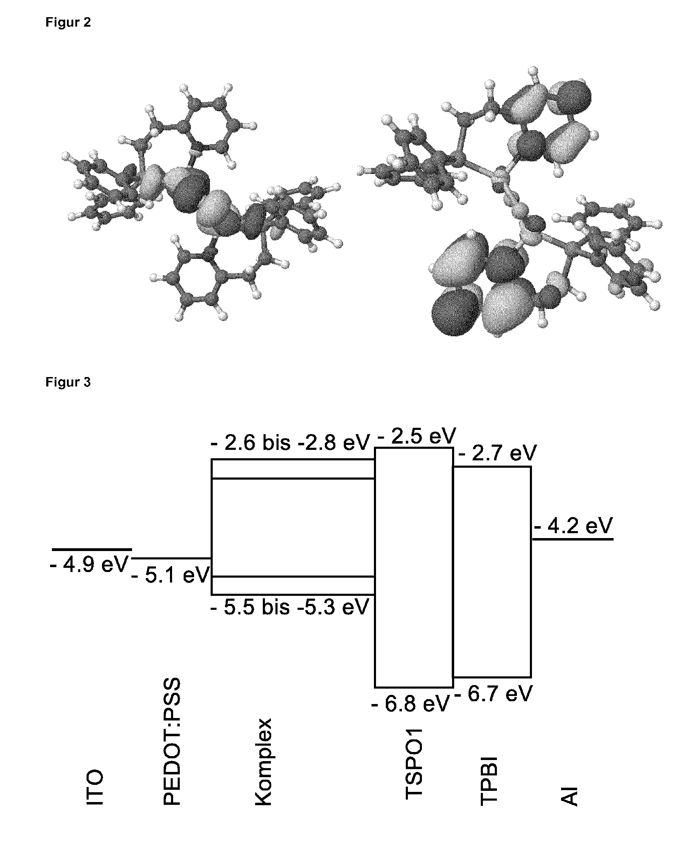

Die Komplexe **10-Cl** bis **10-I** verhalten sich analog zu den entsprechenden heteroleptischen White-Komplexen. Die HOMO-Energien von **10-Br** und **10-I** wurden mit Hilfe von PESA zu -5.30 eV und -5.43 eV bestimmt. Dies spiegelt die Lokalisierung des HOMOs auf der Cu₂X₂-Einheit wider: Durch den Übergang von lod zu Brom steigt die HOMO-Energie entsprechend um ca. 0.1 eV an, was photophysikalisch zu einer Rotverschiebung der Emission führt. DFT-Rechnungen zeigen, dass die Verwendung von Ligand **10** anstelle von Pyridin **A** und Triphenylphosphin **a** die Natur des (M+X)LCT-Übergangs nicht nennenswert beeinflusst (Figur 2).

**Tabelle 1: Photophysikalische Parameter von WhitePHOS-Komplexen.**

| | **λₑₘ(r.t.) [nm]** | **ΔE(S₀,S₁) [eV]** | **PLQY Φ** | **τ^{a}(r.t.) [µs]** | **λₑₘ(77K) [nm]** | **τ^{a} (77K) [µs]** | **ΔE(S₁,T₁) [cm⁻¹]** |
|---|---|---|---|---|---|---|---|
| **10-Cl** | 562 | 2.54 | 0.95 | 0.49 | 590 | 32.62 | 1469 |
| **10-Br** | 540 | 2.67 | 0.76 | 0.70 | 548 | 64.77 | 1247 |
| **10-I** | 430 | 3.05 | 0.35 | 0.54 | 432 | 36.69 | 1178 |

Alle Emissionsdaten wurden an Pulverproben gemessen. Die Anregung erfolgte bei 350 nm (Emission) bzw. 377 nm (τ). ΔE(S₀,S₁) = Aus Excicationsspektren nach Tauc bestimmt. ΔE(S₁,T₁) = Aus der Differenz des Emissionsonsets r.t. - 77K ^{a} = Mittelwert, triexponentieller Fit.

Fehler! Verweisquelle konnte nicht gefunden werden.Tabelle 1 enthält wichtige photophysikalische Eckdaten zu den Komplexen **10-Cl, 10-Br** und **10-I.** Demnach steigen wie erwartet die Bandlücke sowie die Energie des emittierten Lichtes von Cl nach I an. Die Quanteneffizienz nimmt gleichzeitig ab, hat aber für die tiefblaue lodoverbindung **10-I** (430 nm) noch einen sehr hohen Wert von 35 %. Aus der Emissionslebensdauer sowie dem Tieftemperaturverhalten lässt sich schließen, dass die **WhitePHOS-Komplexe** wie die **NHetPHOS-Komplexe** TADF-Emitter sind: Die Emissionslebensdauer ist relativ kurz, wobei bei der Interpretation der Daten beachtet werden muss, dass jeweils triexponentielle Abklingkurven erhalten und die angegebenen Lebendauern demnach Mittelwerte sind. Beim Abkühlen auf 77K steigt die Emissionslebensdauer um beinahe zwei Größenordnungen an. Nach der von Yersin vorgeschlagenen Methode wurde der Energieunterschied zwischen angeregtem Singulett und Triplett-Zustand, ΔE(S₁,T₁), aus dem Anstieg der Emissionsbande (kurzwelliger Bereich der Bande) der Emission bei Raumtemperatur und 77K bestimmt.¹ Der Wert sinkt in der Reihe Cl - Br - I von 1469 auf 1178 cm⁻¹, liegt aber für alle Verbindungen im Bereich der thermischen Energie k_{b}T bei 300 K (ca. 240 cm⁻¹).

### Beispiel 4 Test-OLEDS von 10-I, 10-Br und 10-Cl.

Die Komplex **10-Cl** bis **10-I** wurden in einem OLED-Aufbau getestet, wobei ein Host-freier Reinfilm aus Kupfer(I)-komplex als EML verwendet wurde. Demnach steigt beim Übergang von Iodid nach Chlorid die HOMO-Energie von -5.3 auf -5.5 eV an. Da sich die Bandlücke näherungsweise nicht verändert, steigt die LUMO-Energie in einem vergleichbaren Umfang von -2.6 auf -2.4 eV (Figur 3).

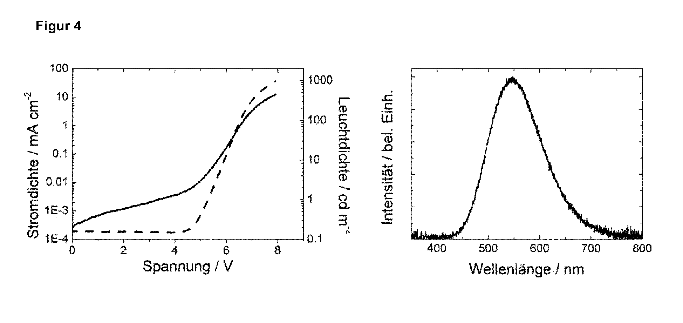

Die Ergebnisse der Tests der erfindungsgemäßen Verbindungen 10-I, 10-Br und 10-Cl in einfachen OLEDs sind in Figur 4 und Tabelle 2 aufgeführt. Wie aufgrund der grundlegenden photophysikalischen Trends von CuX-Komplexen erwartet, verschiebt sich das Maximum des Elektrolumineszenzspektrums beim Übergang von Iodid nach Chlorid von 515 auf 560 nm. Die Effizienz ist beim Bromo-Komplex **10-Br** mit 5.2 Im W⁻¹ am höchsten in der Reihe.

**Tabelle 2: Bauteildaten für Komplexe 10-I, 10-Br und 10-Cl.**

| | **Vₒₙ (1 cd m⁻²) [V]** | **η_{CE}^{a} [cd A⁻¹]** | **η_{CE}^{a} [lm W⁻¹]** | **B^{b} [cd m⁻²]** | **λₑₘ(EL) [nm]** | **λₑₘ(PL) [nm]** | **Φ_{EQE}^{a}** |
|---|---|---|---|---|---|---|---|
| **10-I** | 3.5 | 2.8 | 1.8 | 1120 | 515 | 500 | 1.0% |
| **10**-**Br** | 4.2 | 10.5 | 5.2 | 1830 | 550 | 550 | 2.2% |
| **10-Cl** | 4.5 | 3.1 | 1.6 | 145 | 560 | 555 | 8.0% |

| | | | | | | | |
|---|---|---|---|---|---|---|---|
| ^{a}= gemessen für 1 mA cm⁻². ^{b}= gemessen bei 12 V Einsatzspannung. Photolumineszenzspektroskopie: Anregung bei 350 nm. | | | | | | | |

### Figuren

Es zeigen:
**Figur 1A****/B:** Exemplarische Darstellung des Aufbaus einer organischen lichtemittierenden Diode (OLED).
**Figur 2****:** HOMO (links) und LUMO (rechts) des Komplexes 10-Br
**Figur 3****:** Energieniveau-Diagramm für das Bauteil ITO(130 nm)//PEDOT:PSS (30 nm)//Komplex (30 nm)//TSPO1 (15 nm)//TPBi (15 nm)//LiF(1 nm)//Al(100 nm).
**Figur 4****:** L-I-V Kurve (links; durchgezogene Linie = Stromdichte; gestrichelte Linie = Leuchtdichte) und Elektrolumineszenzspektrum für Komplex **10-Br.**

## Patentansprüche

1. Zweikerniger Metallkomplex, aufweisend eine Struktur gemäß Formel A 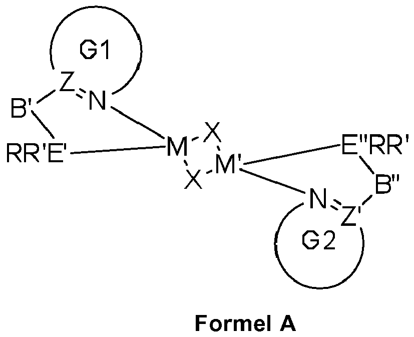 wobei
M/M' = unabhängig ausgewählt aus der Gruppe bestehend aus Cu, Ag, Au;
X = unabhängig ausgewählt aus der Gruppe bestehend aus Cl, Br, I, Pseudohalogenide;
E'/E" = unabhängig ausgewählt aus der Gruppe bestehend aus P, As;
Z/Z' = unabhängig ausgewählt aus der Gruppe bestehend aus N oder C; wobei zwischen
Z/Z' und N entweder eine Einfachbindung oder eine Doppelbindung vorhanden ist;
B'/B" = Brücke mit mindestens 2 bis zu 17 Gliedern; die Glieder können bestehen aus CH₂,
CHR'", CR'"R"", O, S, Se, NR"', PR"', AsR"', wobei R'" ein Rest aus der Gruppe Alkyl, Aryl, Hereroaryl, OR, SR, SeR, H, D sein kann;
G1/G2 = fünf oder sechsgliedriges, heteroaromatisches Ringsystem, welches optional mit weiteren Resten wie R/R' substituiert oder mit weiteren aromatischen Ringen anneliert ist; einer der Reste an G1/G2 kann auch eine weitere Brücke sein, die eine Brücke wie B'/B" aufspannt; durch diese Brücke wird das Ringsystem G1 mit dem Donoratom E" und das Ringsystem G2 mit dem Donoratom E' verbunden;
jedes R und R' ist bei jedem Auftreten gleich oder verschieden H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei optional eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sind und wobei optional ein oder mehrere H-Atome durch Deuterium, F, Cl, Br, I, CN, CF₃ oder NO₂ ersetzt sind, oder ein aromatisches oder heteroaromatisches Ringsystem mit 5 bis 60 aromatischen Ringatomen, das optional jeweils durch einen oder mehrere Reste R² substituiert ist, oder eine Aryloxy- oder Heteroaryloxygruppe mit 5 bis 60 aromatischen Ringatomen, die optional durch einen oder mehrere Reste R² substituiert ist, oder eine Diarylaminogruppe, Diheteroarylaminogruppe oder Arylheteroarylaminogruppe mit 10 bis 40 aromatischen Ringatomen, welche optional durch einen oder mehrere Reste R² substituiert ist, oder eine Kombination dieser Systeme; dabei bilden optional zwei oder mehrere dieser Substituenten R und R' auch miteinander ein mono- oder polycyclisches, aliphatisches, aromatisches und/oder benzoannelliertes Ringsystem;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die optional jeweils mit einem oder mehreren Resten R³ substituiert ist, wobei optional eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sind und wobei optional ein oder mehrere H-Atome durch Deuterium, F, Cl, Br, I, CN, CF₃ oder NO₂ ersetzt sind, oder ein aromatisches oder heteroaromatisches Ringsystem mit 5 bis 60 aromatischen Ringatomen, das optional jeweils durch einen oder mehrere Reste R³ substituiert ist, oder eine Aryloxy- oder Heteroaryloxygruppe mit 5 bis 60 aromatischen Ringatomen, die optioanl durch einen oder mehrere Reste R³ substituiert ist, oder eine Diarylaminogruppe, Diheteroarylaminogruppe oder Arylheteroarylaminogruppe mit 10 bis 40 aromatischen Ringatomen, welche durch einen oder mehrere Reste R³ substituiert ist, oder eine Kombination dieser Systeme; dabei bilden optional zwei oder mehrere dieser Substituenten R² auch miteinander ein mono- oder polycyclisches, aliphatisches, aromatisches und/oder benzoannelliertes Ringsystem;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem optional ein oder mehrere H-Atome durch F oder CF₃ ersetzt sind; dabei bilden optional zwei oder mehrere Substituenten R³ miteinander ein mono- oder polycyclisches, aliphatisches Ringsystem.

2. Metallkomplex nach Anspruch 1, wobei das Ringsystem G1/G2 ausgewählt ist aus der Gruppe bestehend aus einer ungesättigten oder aromatischen N-heterozyklischen Einheit mit 5 oder 6 Ring-Atomen, die ausgewählt ist aus der Gruppe bestehend aus Pyridin, Pyridazin, Pyrimidin, Pyrazin, Triazin, Oxazol, Thiazol, Imidazol, Pyrazol, Isoxazol, Isothiazol, 1,2,3-Triazol, 1,2,4-Triazol, 1,2,4-Oxadiazol, 1,2,4-Thiadiazol, Tetrazol, 1,2,3,4-Oxatriazol, 1,2,3,4-Thiatriazol, die optional mit einem oder mehreren Resten R substituiert ist, wobei optional zwei oder mehr Reste R miteinander verknüpft sind und optional ein Ring oder Ringsystem bilden, insbesondere ein mono- oder polycyclisches, aliphatisches, aromatisches und/oder benzoannelliertes Ringsystem, wobei die Reste R zusammen mit dem zentralen 5- bis 6-Ring optional anellierte Ringsysteme ausbilden, wobei die Koordination an das M/M'-Atom über ein Stickstoffatom der N-heterozyklischen Einheit stattfindet: 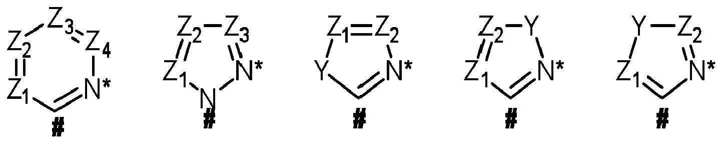 wobei
die Verknüpfung zu B oder zu B' an der mit # gekennzeichneten Stelle stattfindet und * das Atom kennzeichnet, das die Komplexbindung eingeht;
Z¹-Z⁴ = jeweils unabhängig voneinander ausgewählt aus der Gruppe bestehend aus dem Fragment CR und N, mit R ist bei jedem Auftreten gleich oder verschieden H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die optional jeweils mit einem oder mehreren Resten R² substituiert ist, wobei optional eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sind und wobei optional ein oder mehrere H-Atome durch Deuterium, F, Cl, Br, I, CN, CF₃ oder NO₂ ersetzt sind, oder ein aromatisches oder heteroaromatisches Ringsystem mit 5 bis 60 aromatischen Ringatomen, das optional jeweils durch einen oder mehrere Reste R² substituiert ist, oder eine Aryloxy- oder Heteroaryloxygruppe mit 5 bis 60 aromatischen Ringatomen, die optional durch einen oder mehrere Reste R² substituiert ist, oder eine Diarylaminogruppe, Diheteroarylaminogruppe oder Arylheteroarylaminogruppe mit 10 bis 40 aromatischen Ringatomen, welche optional durch einen oder mehrere Reste R² substituiert ist, oder eine Kombination dieser Systeme;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R², S(=O)₂R³, OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die optional jeweils mit einem oder mehreren Resten R³ substituiert sind, wobei optional eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sind und wobei optional ein oder mehrere H-Atome durch Deuterium, F, Cl, Br, I, CN, CF₃ oder NO₂ ersetzt sind, oder ein aromatisches oder heteroaromatisches Ringsystem mit 5 bis 60 aromatischen Ringatomen, das optional jeweils durch einen oder mehrere Reste R³ substituiert ist, oder eine Aryloxy- oder Heteroaryloxygruppe mit 5 bis 60 aromatischen Ringatomen, die optional durch einen oder mehrere Reste R³ substituiert ist, oder eine Diarylaminogruppe, Diheteroarylaminogruppe oder Arylheteroarylaminogruppe mit 10 bis 40 aromatischen Ringatomen, welche optional durch einen oder mehrere Reste R³ substituiert ist, oder eine Kombination dieser Systeme; dabei bilden optional zwei oder mehrere dieser Substituenten R² auch miteinander ein mono- oder polycyclisches, aliphatisches, aromatisches und/oder benzoannelliertes Ringsystem;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem optional ein oder mehrere H-Atome durch F oder CF₃ ersetzt sind; dabei bilden optional zwei oder mehrere Substituenten R³ miteinander ein mono- oder polycyclisches, aliphatisches Ringsystem.

3. Metallkomplex nach Anspruch 1 oder 2, wobei die Brückenlänge der Brücke B/B' 2 bis 4 substituierte oder unsubstituierte Einheiten aufweist, insbesondere aus 2 bis 4 substituierte oder unsubstituierte Einheiten besteht.

4. Metallkomplex nach Anspruch 1 bis 3, wobei
E'/E" = P,
M/M' = Cu und/oder
X = unabhängig ausgewählt aus der Gruppe bestehend aus Cl, Br, I, Pseudohalogenide.

5. Metallkomplex nach Anspruch 1 bis 4 mit einer der folgenden Strukturen 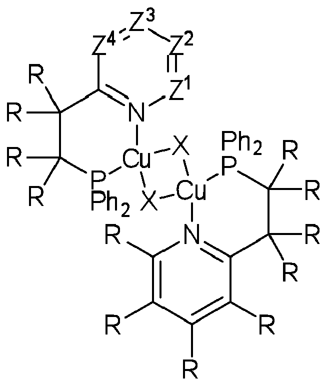 wobei die Gruppen und Reste wie in Anspruch 1 bis 3 definiert sind, wobei bevorzugt Z¹ bis Z⁴ gleich CR sind.

6. Metallkomplex nach Anspruch 1 bis 4 mit einer der folgenden Strukturen 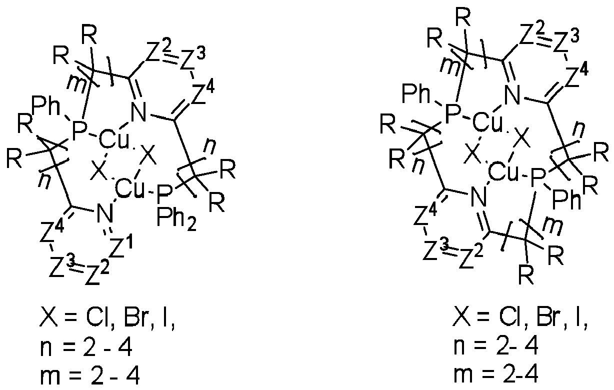 wobei die angegebenen Gruppen und Reste wie in Anspruch 1 bis 3 definiert sind.

7. Verfahren zur Herstellung eines zweikernigen Metallkomplexes nach Anspruch 1 bis 6, aufweisend den Schritt der Substitution mindestens eines Ligands E∩D mit mindestens einer funktionellen Gruppe zur Verbesserung des Ladungsträgertransports, die ausgewählt ist aus der Gruppe bestehend aus Elektronenleiter und Lochleiter.

8. Verwendung eines Metallkomplexes nach Anspruch 1 bis 6 als Emitter oder Absorber in einem optoelektronischen Bauelement, insbesonder in einem optoelektronischen Bauelement, das durch ein Vakuumverdampfungsverfahren oder aus Lösung hergestellt wird.

9. Verwendung nach Anspruch 8, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- Organischen Solarzellen,
- Organischen Feldeffekttransistoren,
- Organischen Lasern und
- Down-Konversions-Elementen.

10. Optoelektronisches Bauelement, aufweisend einen Metall(I)komplex nach Anspruch 1 bis 6.

11. Optoelektronisches Bauelement nach Anspruch 10, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

12. Optoelektronisches Bauelement nach Anspruch 10 oder 11, **dadurch gekennzeichnet, dass** der Metall(I)komplex als Emissionsmaterial in einer Emissionsschicht eingesetzt ist, wobei er entweder als Reinschicht oder in Kombination mit einem Matrixmaterial eingesetzt ist.

13. Optoelektronisches Bauelement nach Anspruch 12, insbesondere in Form einer organischen Elektrolumineszenzvorrichtung, **dadurch gekennzeichnet, dass** das Matrixmaterial ausgewählt ist aus der Gruppe bestehend aus Ketonen, Phosphinoxiden, Sulfoxiden, Sulfonen, Triarylaminen, Carbazolderivaten, Phenoxazinderivaten, Phenothiazinderivaten, Indolocarbazolderivaten, Azacarbazolen, bipolaren Matrixmaterialien, Silanen, Azaborolen, Boronestern, Triazinderivaten, Zinkkomplexen, Diazasilol- und Tetraazasilol-Derivaten, Benzophenonderivaten, Diphenylmethanderivate, Ultra-High-Energy-Gap-Matrixmatrialien und Mischungen aus zwei oder mehr der vorstehend genannten Matrixmaterialien.

14. Optoelektronisches Bauelement nach Anspruch 10 bis 13, aufweisend ein Substrat, eine Anode, eine Kathode und mindestens eine lichtemittierende Schicht, die einen Metallkomplex nach Anspruch 1 bis 6 und ein Hostmaterial aufweist, dessen Triplett (T1)-und Singulett (S1)-Energieniveaus energetisch höher liegen als die Triplett (T1)- und Singulett (S1)-Energieniveaus des Metallkomplexes nach Anspruch 1 bis 6, wobei die Anode und die Kathode auf das Substrat aufgebracht wird, und die lichtemittierende Schicht zwischen Anode und Kathode aufgebracht ist.

15. Optoelektronisches Bauelement nach Anspruch 14, weiterhin aufweisend
- mindestens eine löcherinjizierende Schicht,
- mindestens eine elektroneninjizierende Schicht,
- mindestens eine löchertransportierende Schicht und
- mindestens eine elektronentransportierende Schicht
wobei
- die löcherinjizierende Schicht zwischen der Anode und der löchertransportierenden Schicht
- die elektroneninjizierende Schicht zwischen der Kathode und der elektronentransportierenden Schicht und
- die lichtemittierende Schicht zwischen der löcher- und der elektronentransportierenden Schicht aufgebracht ist.

16. Verfahren zur Herstellung eines optoelektronischen Bauelements, wobei ein Metallkomplex nach Anspruch 1 bis 6 verwendet wird.

17. Verfahren nach Anspruch 16, **gekennzeichnet durch** das Aufbringen eines Metallkomplexes nach Anspruch 1 bis 6 auf einen Träger.

18. Verfahren nach Anspruch 17, **dadurch gekennzeichnet, dass** das Aufbringen nass-chemisch, mittels kolloidaler Suspension oder mittels Sublimation erfolgt.

19. Verfahren zur Veränderung der Emissions- und/oder Absorptionseigenschaften eines elektronischen Bauelements, **gekennzeichnet durch** Einbringen eines Metall(I)komplexes nach Anspruch 1 bis 6 in ein Matrixmaterial zur Leitung von Elektronen oder Löchern in ein optoelektronisches Bauelement, insbesondere mittels Vakuumverdampfung.

20. Verfahren zur Herstellung eines optoelektronischen Bauelements nach Anspruch 10 bis 15 in Form einer organischen Elektrolumineszenzvorrichtung, **dadurch gekennzeichnet, dass** mindestens eine Schicht mit einem Sublimationsverfahren beschichtet wird oder dass mindestens eine Schicht mit einem OVPD (Organic Vapour Phase Deposition) Verfahren oder mit Hilfe einer Trägergassublimation beschichtet wird oder dass mindestens eine Schicht aus Lösung oder mit einem beliebigen Druckverfahren hergestellt wird.

21. Verwendung eines Metallkomplexes nach Anspruch 1 bis 6, insbesondere in einem optoelektronischen Bauelement zur Umwandlung von UV-Strahlung oder von blauem Licht in sichtbares Licht, insbesondere in grünes, gelbes oder rotes Licht (Down-Konversion).

22. Zusammensetzung, aufweisend einen Metallkomplex nach Anspruch 1 bis 6 und ein Hostmaterial, wobei die Triplett (T1)- und Singulett (S1)-Energieniveaus des Hostmaterials energetisch höher liegen als die Triplett (T1)- und Singulett (S1)-Energieniveaus des Metallkomplexes, und wobei der Metallkomplex Fluoreszenz oder thermisch aktivierte verzögerte Fluoreszenz zeigt, und einen ΔE(S1-T1)-Wert zwischen dem untersten angeregten Singulett (S1)- und dem darunter liegenden Triplett (T1)-Zustand von kleiner als 2000 cm⁻¹ aufweist.
